(19) Europäisches Patentamt
European Patent Office
Office européen des brevets

(11) **EP 3 252 482 B1**

(12) **EUROPÄISCHE PATENTSCHRIFT**

(45) Veröffentlichungstag und Bekanntmachung des Hinweises auf die Patenterteilung:
**17.02.2021 Patentblatt 2021/07**

(51) Int Cl.:
*G01R 19/25* *(2006.01)*    *G01R 25/00* *(2006.01)*
*H02J 3/24* *(2006.01)*

(21) Anmeldenummer: **16172418.2**

(22) Anmeldetag: **01.06.2016**

(54) **VERFAHREN UND LEITSTELLENEINRICHTUNG ZUM BESTIMMEN EINES PHASENWINKELS EINER LEISTUNGSPENDELUNG IN EINEM ELEKTRISCHEN ENERGIEVERSORGUNGSNETZ**

METHOD AND CONTROL CENTRE DEVICE FOR DETERMINING A PHASE ANGLE OF A POWER OSCILLATION IN AN ELECTRICAL POWER SUPPLY SYSTEM

PROCEDE ET DISPOSITIF DE CENTRE DE CONTROLE DESTINES A DETERMINER UN ANGLE DE PHASE D'UNE OSCILLATION DE PUISSANCE DANS UN RESEAU D'ALIMENTATION ELECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.12.2017 Patentblatt 2017/49**

(73) Patentinhaber: **Siemens Aktiengesellschaft 80333 München (DE)**

(72) Erfinder: **Piel, Stefan 45359 Essen (DE)**

(56) Entgegenhaltungen:
EP-A1- 1 489 714    US-A1- 2009 099 798
US-A1- 2009 222 144    US-A1- 2013 204 557

EP 3 252 482 B1

**Beschreibung**

Die Erfindung betrifft ein Verfahren und eine Leitstelleneinrichtung zum Bestimmen eines Phasenwinkels einer Leistungspendelung in einem elektrischen Energieversorgungsnetz.

Um einen reibungslosen und sicheren Betrieb elektrischer Energieversorgungsnetze zu gewährleisten, werden in sogenannten Netzleitstellen für den Netzzustand charakteristische Messwerte des elektrischen Energieversorgungsnetzes überwacht, um zu ermitteln, ob sich das Energieversorgungsnetz in seinem bestimmungsgemäßen Betriebszustand oder aber einem kritischen Zustand befindet. Hierzu werden an ausgewählten Messstellen des elektrischen Energieversorgungsnetzes Messwerte elektrischer Messgrößen, wie z.B. Strom, Spannung und Leistung, mittels geeigneter Wandler erfasst und üblicherweise in digitaler Form der Netzleitstelle zur Auswertung und Beobachtung zugeführt. Um einen zeitlichen Bezug der einzelnen Messwerte zueinander zu gewährleisten, werden die aufgenommenen Messwerte üblicherweise um sogenannte Zeitstempel, also Uhrzeitinformationsdaten, ergänzt, die z.B. diejenige Uhrzeit angeben, zu denen die Messwerte erfasst worden sind. Solche Zeitstempel können beispielsweise mit einer Genauigkeit von einer Mikrosekunde vergeben werden. Die Messwerte werden beispielsweise mit sogenannten Zeigermesseinrichtungen bzw. "Phasor Measurement Units" (PMUs) als komplexe Strom- oder Spannungszeiger erfasst, die eine Aussage über Amplitude und Phasenwinkel der an der jeweiligen Messstelle des elektrischen Energieversorgungsnetzes zu messenden Messgröße umfassen. Solche Zeigermesswerte werden mit Abtastraten von z.B. 10 Hz und höher erfasst.

Eine Form eines kritischen Betriebszustands eines elektrischen Energieversorgungsnetzes stellen sogenannte "Leistungspendelungen" (im Folgenden auch als "Pendelungen" bezeichnet) dar. Solche Pendelungen können sich aufgrund elektro-mechanischer Wechselwirkungen zwischen rotierenden Energieerzeugungseinheiten (Generatoren) untereinander sowie mit dem von ihnen mit elektrischer Energie gespeisten Netz ausbilden. Beispielsweise entstehen Pendelungen bei plötzlichen Laständerungen oder Veränderungen an der Struktur des elektrischen Energieversorgungsnetzes (beispielsweise durch Zu- oder Abschalten größerer Netzteile). Hierbei müssen sich die Generatoren mit ihren mechanisch rotierenden Elementen an den Einspeisestellen des elektrischen Energieversorgungsnetzes auf die neue Lastsituation einstellen. Dies geschieht üblicherweise in Form einer gedämpften Schwingung mit einer Frequenz von wenigen Hertz oder geringer, bis sich der neue Arbeitspunkt des elektrischen Energieversorgungsnetzes stabilisiert hat. Durch das Einschwingverhalten der Generatoren werden pendelnde Strom- und Spannungszustände im Energieversorgungsnetz erzeugt, die unterschiedliche Auswirkungen auf das Energieversorgungsnetz und seine elektrischen Komponenten (z.B. Leitungen, Kabel, Transformatoren) haben können. Während gedämpfte Pendelungen mit vergleichsweise niedrigen Amplituden im Energieversorgungsnetz relativ schnell abklingen und daher akzeptiert werden können, stellen insbesondere schwach gedämpfte oder sogar sich aufschaukelnde Pendelungen einen höchst kritischen Zustand des Energieversorgungsnetzes dar, der leicht zu Ausfällen und Abschaltungen größerer Netzabschnitte führen kann. Außerdem kann durch die sich bei Ausfällen einzelner Netzabschnitte sprunghaft verändernde Netzstruktur eine Überlastung noch funktionsfähiger Abschnitte des elektrischen Energieversorgungsnetzes erfolgen, was zu kaskadierenden Abschaltungen bis hin zu einem sogenannten Blackout führen kann. Das Vorliegen einer Leistungspendelung in einem elektrischen Energieversorgungsnetz kann anhand von Messungen zugehöriger elektrischer Größen an geeigneten Messstellen im Energieversorgungsnetz nachgewiesen werden. Eine solche messtechnische Ermittlung von Pendelvorgängen in Energieversorgungsnetzen ist beispielsweise aus der WO 2013/087122 A1 bekannt. Hier werden bestehende Pendelvorgänge anhand ihrer Parameter "Amplitude" und "Dämpfung" erkannt und verschiedenen Gefährdungsbereichen zugeordnet, die ein Gefährdungspotential der Pendelung angeben.

Ein relevantes Dokument aus dem Stand der Technik ist US2009/099798A1.

Auch aus der WO 2014/056531 A2 ist die Erkennung von Pendelvorgängen bekannt. Um eine möglichst effiziente messtechnische Erfassung vornehmen zu können, wird hier die Verwendung von Messfenstern unterschiedlicher Länge vorgeschlagen. Befindet sich in einem elektrischen Energieversorgungsnetz eine Vielzahl von Generatoren, so können diese in verschiedener Weise an einer vorliegenden Leistungspendelung teilhaben. Beispielsweise können einzelne Generatoren oder Gruppen von Generatoren gleichphasig oder gegenphasig schwingen bzw. überhaupt nicht an einer Pendelung der anderen Generatoren teilhaben. Das jeweilige Verhalten lässt sich durch die Ermittlung der Phasenlage der Pendelung in der Nähe des jeweiligen Generators bestimmen. Der Vergleich der Phasenlage der Pendelung an verschiedenen Messorten ermöglicht somit eine Aussage darüber, ob und in welcher Weise die einzelnen Generatoren untereinander elektro-mechanisch gekoppelt sind, also elektrisch miteinander oder gegeneinander schwingen. Durch frühzeitige Detektion und Bewertung des Verhaltens der einzelnen Generatoren während einer Pendelung wird der Netzbetreiber in die Lage versetzt, die Notwendigkeit etwaiger erforderlicher Gegenmaßnahmen zu erkennen und diese zeitnah und gezielt durchzuführen.

Die Kenntnis über die Phasenbeziehung von einzelnen Generatoren oder Generatorgruppen, die im Netz gegeneinander Leistungspendelungen ausführen (also in Phasenopposition sind), liefert gemeinsam mit der Kenntnis über Stärke und Dämpfung dieser Vorgänge die Informationen über die Kleinsignal-Stabilität, also dem Verhalten des Netzes gegenüber sich kontinuierlich verändernder Lasten und Schaltvorgängen in demselben. Dieses Wissen kann im Vorfeld für die optimale Einstellung von Pendeldämpfungsgeräten der Generatoren (z.B. sogenannte "PSS" = "Power System Stabilizer") oder weiterer im Netz befindlicher Regel-Einheiten (z.B. "FACTS" = "Flexib-le AC Transmission Systems") genutzt werden; ebenso können im laufenden Betrieb beim Auftreten von Pendelungen gezielt Anpassungen zur Abschwächung ihrer Amplituden vorgenommen werden.

Wenn im Zusammenhang mit der vorliegenden Erfindung die Ausdrücke "Phasenwinkel" bzw. "Phasenlage" verwendet werden, so ist hiermit der Phasenwinkel einer Leistungspendelung im Vergleich zu einem Referenzphasenwinkel gemeint. Dieser Referenzphasenwinkel kann entweder systemweit festgelegt sein oder sich auf den Phasenwinkel einer als Referenz festgelegten Messstelle beziehen.

Zur Bestimmung der Phasenlage eines schwingenden Messsignals ist beispielsweise die Anwendung der sogenannten "Prony-Methode" bekannt. Hierdurch wird - gemeinsam mit anderen Parametern wie Frequenz und Amplitude - die Phasenlage des Messsignals ermittelt. Die Verwendung der Prony-Methode zur Ermittlung der Parameter eines Messsignals wird beispielsweise in der US 7,692,336 B2 beschrieben. Nachteilig hieran ist bei der Bewertung von Pendelungen jedoch insbesondere, dass für die betrachtete Pendelung innerhalb eines Zeitintervalls, in dem die zur Auswertung herangezogenen Messdaten liegen, konstante Werte für Frequenz und Dämpfung der Pendelung erwartet werden. Dies verhindert insbesondere bei gerade einsetzenden Pendelvorgängen eine frühzeitige Verfügbarkeit der Ergebnisse, so dass die Information über die Phasenlage erst vergleichsweise spät abgegeben werden kann.

Der Erfindung liegt daher die Aufgabe zugrunde, ein Verfahren anzugeben, mit dem vergleichsweise schnell und insbesondere auch zeitnah nach dem Beginn einer Pendelung in einem elektrischen Energieversorgungsnetz eine Information über die Phasenlage der Pendelung bereitgestellt werden kann. Der Erfindung liegt auch die Aufgabe zugrunde, eine entsprechende Leitstelleneinrichtung anzugeben, mit der ein solches Verfahren ausgeführt werden kann.

Diese Aufgabe wird hinsichtlich des Verfahrens durch ein Verfahren zum Bestimmen eines Phasenwinkels einer Leistungspendelung in einem elektrischen Energieversorgungsnetz gelöst, bei dem für eine Messstelle des elektrischen Energieversorgungsnetzes ein zeitlicher Verlauf einer elektrischen Leistung bestimmt wird, unter Verwendung des Verlaufs der elektrischen Leistung eine Erkennung einer oder mehrerer Pendelmoden einer Leistungspendelung vorgenommen wird,, indem eine Analyse von in dem zeitlichen Verlauf der elektrischen Leistung enthaltenen Frequenzen vorgenommen wird und die vorherrschenden Frequenzen als zu den vorliegenden Pendelmoden gehörende Frequenzen erkannt werden; für die Frequenzen der ermittelten Pendelmoden ein künstlicher Verlauf einer elektrischen Leistung berechnet wird, der einen Signalverlauf angibt, den ein Pendelvorgang der elektrischen Leistung mit einer einzigen Pendelmode idealerweise haben würde; der künstliche Verlauf unter Variation des zur Berechnung verwendeten Phasenwinkels mit dem erfassten zeitlichen Verlauf der elektrischen Leistung oder einem daraus abgeleiteten Verlauf verglichen wird, indem bei Erkennung einer einzelnen Pendelmode der Vergleich des künstlichen Verlaufs mit dem erfassten zeitlichen Verlauf der elektrischen Leistung durchgeführt wird oder bei Erkennung mehrerer Pendelmoden für jede der erkannten Pendelmoden ein abgeleiteter Verlauf der elektrischen Leistung gebildet wird, der ausschließlich die Frequenz der jeweiligen Pendelmode enthält, der Vergleich des künstlichen Verlaufs mit dem abgeleiteten Verlauf der elektrischen Leistung durchgeführt wird; und derjenige zur Berechnung des künstlichen Verlaufs verwendete Phasenwinkel als Phasenwinkel der Leistungspendelung ermittelt wird, bei dem der künstliche Verlauf und der erfasste zeitliche Verlauf oder der daraus abgeleitete Verlauf die geringste Abweichung voneinander aufweisen.

Unter einer Pendelmode soll im Rahmen dieser Erfindung ein Pendelvorgang zwischen zwei oder mehr Generatoren verstanden werden, der sich im Wesentlichen durch eine bestimmte Pendelfrequenz auszeichnet.

Für die Ermittlung des Phasenwinkels findet bei dem erfindungsgemäßen Verfahren somit ein Vergleich des erfassten zeitlichen Verlaufs bzw. eines davon abgeleiteten Verlaufs mit einem künstlichen Verlauf statt, der den Signalverlauf angibt, den idealerweise ein Pendelvorgang mit einer einzigen Pendelmode (und damit einer eindeutigen Frequenz) haben würde. Durch Vergleich beider Verläufe unter Variation des angenommenen Phasenwinkels und Minimierung der Abweichungen lässt sich der künstliche Verlauf so weit verschieben, bis eine weitgehende Deckungsgleichheit erzielt worden ist. Der hierfür angenommene Phasenwinkel wird dann als Phasenwinkel der Leistungspendelung an der Messstelle verwendet.

Der besondere Vorteil des erfindungsgemäßen Verfahrens liegt darin, dass hiermit vergleichsweise schnell und genau eine Information über den vorliegenden Phasenwinkel einer Leistungspendelung ermittelt werden kann. Da nämlich bei einer gerade einsetzenden Leistungspendelung diejenigen Zeitbereiche des der Auswertung zugrunde liegenden Datensatzes eines Verlaufs von Messwerten der elektrischen Leistung, in denen noch keine Leistungspendelung vorhanden ist, gegenüber denjenigen Zeitbereichen, in denen eine solche Pendelung bereits nachweisbar ist, nur einen vernachlässigbaren Einfluss auf das Ergebnis der Frequenzerkennung und damit der Optimierungsmethode zur Ermittlung des Phasenwinkels hat, liefern auch Datensätze, die aufgrund einer gerade einsetzenden Leistungspendelung in nur einem vergleichsweise kleinen Zeitbereich ein Pendelverhalten zeigen, verwertbare Messwerte. Damit sind Informationen über die Phasenlage einer Leistungspendelung bereits kurz nach deren Einsetzen verfügbar.

Als elektrische Leistung wird in diesem Zusammenhang bevorzugt die elektrische Wirkleistung ermittelt.

Je nach Anzahl der in dem Energieversorgungsnetz vorliegenden Pendelvorgänge können an den Messstellen einzelne oder mehrere Pendelmoden erkennbar sein. Liegen an einer Messstelle mehrere Pendelmoden vor, so deutet dies auf entsprechend mehrere, sich überlagernde Pendelvorgänge hin.

Erfindungsgemäß kann eine vergleichsweise einfache Erkennung der jeweiligen Pendelmode stattfinden, da die Frequenz eines Pendelvorgangs als wesentliches Kriterium zur Erkennung einer Pendelmode herangezogen werden kann.

Gemäß der Erfindung ist vorgesehen, dass bei Erkennung einer einzelnen Pendelmode der Vergleich des künstlichen Verlaufs unmittelbar mit dem erfassten zeitlichen Verlauf der elektrischen Leistung durchgeführt wird.

Dieser Fall ist besonders einfach zu handhaben, da der Verlauf der ursprünglich erfassten Messwerte keine Überlagerung mehrerer Pendelvorgänge umfasst. Es kann somit der Vergleich mit dem erfassten zeitlichen Verlauf durchgeführt werden, ohne dass weitere Verarbeitungen des erfassten zeitlichen Verlaufs notwendig wären.

Alternativ ist vorgesehen, dass bei Erkennung mehrerer Pendelmoden für jede der erkannten Pendelmoden ein abgeleiteter Verlauf der elektrischen Leistung gebildet wird, der ausschließlich die Frequenz der jeweiligen Pendelmode enthält, und der Vergleich des künstlichen Verlaufs mit dem abgeleiteten Verlauf der elektrischen Leistung durchgeführt wird.

Dies betrifft den Fall, dass an der Messstelle nicht nur ein Pendelvorgang, sondern mehrere sich überlagernde Pendelvorgänge erkennbar sind. Die zugehörigen Pendelmoden können im Frequenzspektrum aufgrund ihrer jeweiligen Frequenz voneinander unterschieden werden. Zur Ermittlung des Phasenwinkels jedes einzelnen Pendelvorgangs sind daraufhin für jede erkannte Pendelmode anhand ihrer Frequenz einerseits der künstliche Verlauf und andererseits ein abgeleiteter Verlauf zu bilden. Diese beiden Verläufe sind dann zur Ermittlung des Phasenwinkels heranzuziehen.

Gemäß einer vorteilhaften Ausführungsform des erfindungsgemäßen Verfahrens ist vorgesehen, dass zur Analyse der in dem zeitlichen Verlauf enthaltenen Frequenzen eine Transformation des zeitlichen Verlaufs in den Frequenzbereich durchgeführt wird und diejenigen Frequenzen als vorherrschend erkannt werden, deren jeweilige Amplitude im Frequenzbereich einen Amplitudenschwellenwert überschreitet.

Diese Vorgehensweise hat den Vorteil, dass sie mit vergleichsweise einfachen und erprobten Mitteln geeignete Ergebnisse zur Pendelmodenerkennung liefert. Konkret kann die Transformation beispielsweise durch eine FFT (Fast Fourier Transformation) bzw. eine DFT (Discrete Fourier Transformation) stattfinden. Die Schwellenwerte können fix vorgegeben sein oder sich adaptiv an das jeweils vorliegende Frequenzspektrum anpassen (z.B. einen bestimmten Prozentwert des jeweils vorliegenden Maximums im Frequenzspektrum annehmen).

Eine weitere vorteilhafte Ausführungsform des erfindungsgemäßen Verfahrens sieht zudem vor, dass der abgeleitete Verlauf der elektrischen Leistung durch Transformation eines die wesentlichen Anteile der jeweiligen Pendelmode enthaltenden Frequenzbereiches eines Frequenzspektrums des erfassten zeitlichen Verlaufs der elektrischen Leistung in den Zeitbereich gebildet wird.

Die wesentlichen Anteile umfassen hierbei zumindest die vorherrschende Frequenz, die der fraglichen Pendelmode zugeordnet wird, können darüber hinaus aber auch benachbarte Frequenzbereiche einschließen.

Gemäß einer weiteren vorteilhaften Ausführungsform des erfindungsgemäßen Verfahrens ist vorgesehen, dass zur Bestimmung desjenigen Phasenwinkels, bei dem der künstliche Verlauf und der erfasste zeitliche Verlauf die geringste Abweichung voneinander aufweisen, ein mathematisches Optimierungsverfahren durchgeführt wird.

Die Optimierungsfunktion kann beispielsweise auf Minimierung der Abweichungen zwischen beiden betrachteten Verläufen bei Variation des Phasenwinkels gerichtet sein.

Konkret kann in diesem Zusammenhang vorgesehen sein, dass als mathematisches Optimierungsverfahren die Methode der kleinsten Fehlerquadrate oder ein Newton-Raphson-Verfahren oder ein Gauß-Newton-Verfahren verwendet wird.

Diese Verfahren sind hinlänglich bekannt und liefern geeignete Ergebnisse für die Ermittlung des Phasenwinkels.

Eine weitere vorteilhafte Ausführungsform des erfindungsgemäßen Verfahrens sieht zudem vor, dass der ermittelte Phasenwinkel auf einer Anzeigeeinrichtung einer Leitstelleneinrichtung angezeigt wird.

Hierdurch kann dem Betreiber des Energieversorgungsnetzes der Wert des Phasenwinkels direkt optisch angezeigt werden. Die Anzeige kann beispielsweise über ein Display oder einen mit der Leitstelleneinrichtung verbundenen Monitor erfolgen. Die Anzeigeeinrichtung kann den Phasenwinkel z.B. als Zeiger in einer Netztopologie des Energieversorgungsnetzes darstellen.

Eine weitere vorteilhafte Ausführungsform des erfindungsgemäßen Verfahrens sieht vor, dass zur Bestimmung des zeitlichen Verlaufs der elektrischen Leistung an der Messstelle Messwerte von Strom und Spannung erfasst werden.

Messwerte von Strom und Spannung werden für mannigfaltige Anwendungen bei der Automatisierung von Energieversorgungsnetzen genutzt, so dass ihre Erfassung keinen zusätzlichen Aufwand darstellen dürfte.

In diesem Zusammenhang kann konkret vorgesehen sein, dass die Messwerte von Strom und Spannung an der Messstelle als zeitgestempelte Zeigermesswerte erfasst werden.

Die Messung kann beispielsweise mit sogenannten "Zeigermesseinrichtungen" (Phasor Measurement Units - PMUs) erfolgen.

Eine weitere vorteilhafte Ausführungsform des erfindungsgemäßen Verfahrens sieht zudem vor, dass die Bestimmung des Phasenwinkels der Leistungspendelung für mehrere Messstellen durchgeführt wird, wobei jede Messstelle einem elektrische Energie in das Energieversorgungsnetz einspeisenden Generator zugeordnet ist, und durch Vergleich der für die einzelnen Messstellen ermittelten Phasenwinkel eine Erkennung durchgeführt wird, welche Generatoren elektro-mechanisch miteinander gekoppelt sind. Quasi findet dabei ein Vergleich der an den verschiedenen Messstellen gefundenen Pendelmoden (anhand von Frequenz und ggf. Dämpfung) statt, bei dem ermittelt wird, welche Generatoren an der gleichen Mode beteiligt und damit untereinander gekoppelt sind bzw. in welcher Weise die an der gleichen Pendelmode beteiligten Generatoren untereinander gekoppelt sind.

Auf diese Weise kann durch Bestimmung des Phasenwinkels an mehreren - möglichst in der Nähe der jeweiligen Generatoren angeordneten - Messstellen und durch Vergleich der ermittelten Phasenwinkel eine Übersicht über die im Netz vorliegenden Pendelvorgänge und ihre Zusammenhänge erzeugt werden. Anhand einer solchen Übersicht kann der Betreiber des Energieversorgungsnetzes bei Bedarf Gegenmaßnahmen zur Dämpfung der Pendelungen einleiten.

In diesem Zusammenhang kann beispielsweise vorgesehen sein, dass solche Generatoren oder Gruppen derselben, für die die ermittelten Phasenwinkel eine Differenz von näherungsweise 0° aufweisen, als phasengleich erkannt werden, und solche Generatoren oder Gruppen derselben, für die die ermittelten Phasenwinkel eine Differenz von näherungsweise 180° aufweisen, als gegenphasig erkannt werden.

Gegenphasig pendelnde Generatoren bilden üblicherweise miteinander die gegenüberliegenden Enden eines Pendelvorgangs, d.h. sie sind für das Vorliegen der fraglichen Pendelung verantwortlich. In Phase pendelnde Generatoren können zwar auch an demselben Pendelvorgang beteiligt sein, liegen jedoch an demselben Ende der Pendelung und bilden somit eine Gruppe von Generatoren, die gegen mindestens einen entfernten Generator pendelt. In Phase pendelende Generatoren sind üblicherweise örtlich näher beieinander angeordnet als gegenphasig pendelnde Generatoren. Durch die Analyse des Zusammenhangs der einzelnen bestimmten Phasenwinkel können somit die elektrisch auf einer Seite oder auf gegenüberliegenden Seiten an der Pendelung beteiligten Generatoren gut erkannt werden.

Um die Genauigkeit bei der Ermittlung des Phasenwinkels weiter zu erhöhen, wird gemäß einer weiteren vorteilhaften Ausführungsform des erfindungsgemäßen Verfahrens schließlich vorgeschlagen, dass die Ermittlung des Phasenwinkels wiederholt unter Variation der verwendeten Frequenz durchgeführt wird, und nachfolgend derjenige Phasenwinkel, bei dem die Abweichung zwischen dem künstlichen Verlauf und dem erfassten zeitlichen Verlauf der elektrischen Leistung oder dem daraus abgeleiteten Verlauf am geringsten ausfällt, als der tatsächliche Phasenwinkel der Leistungspendelung verwendet wird.

Hierdurch können Abweichungen des ermittelten Phasenwinkels der Pendelung vom tatsächlichen Phasenwinkel, die auf Ungenauigkeiten bei der Ermittlung der Frequenz der Pendelmode zurückzuführen sind, weiter verringert werden. Da jedoch davon ausgegangen werden kann, dass die zunächst zur Ermittlung des Phasenwinkels verwendete Frequenz der Pendelmode bereits vergleichsweise genau bestimmt werden konnte, bietet sich zur weiteren Erhöhung der Genauigkeit insbesondere eine Variation der Frequenz insbesondere um den Wert der ursprünglich ermittelten Frequenz an. Alternativ oder zusätzlich kann eine Verbesserung der Genauigkeit des Verfahrens auch durch entsprechende Variation der Amplitude und/oder der Dämpfung erfolgen.

Die oben genannte Aufgabe wird auch durch eine Leitstelleneinrichtung zum Bestimmen eines Phasenwinkels einer Leistungspendelung in einem elektrischen Energieversorgungsnetz mit einer Kommunikationseinrichtung zum Empfang von mittels einer Messeinrichtung an einer Messstelle des Energieversorgungsnetzes aufgenommenen Messwerten und einer Recheneinrichtung zur Bestimmung eines zeitlichen Verlaufs einer elektrischen Leistung für die Messstelle aus den Messwerten gelöst.

Erfindungsgemäß ist vorgesehen, dass die Recheneinrichtung dazu eingerichtet ist, unter Verwendung des Verlaufs der elektrischen Leistung eine Erkennung einer oder mehrerer Pendelmoden einer Leistungspendelung vorzunehmen, indem eine Analyse von in dem zeitlichen Verlauf der elektrischen Leistung enthaltenen Frequenzen vorgenommen wird und die vorherrschenden Frequenzen als zu den vorliegenden Pendelmoden gehörende Frequenzen erkannt werden; für die Frequenzen der ermittelten Pendelmoden einen künstlichen Verlauf einer elektrischen Leistung zu berechnen, der einen Signalverlauf angibt, den ein Pendelvorgang der elektrischen Leistung mit einer einzigen Pendelmode idealerweise haben würde; den künstlichen Verlauf unter Variation des zur Berechnung verwendeten Phasenwinkels mit dem erfassten zeitlichen Verlauf der elektrischen Leistung oder einem daraus abgeleiteten Verlauf zu vergleichen, indem bei Erkennung einer einzelnen Pendelmode der Vergleich des künstlichen Verlaufs mit dem erfassten zeitlichen Verlauf der elektrischen Leistung durchgeführt wird oder bei Erkennung mehrerer Pendelmoden für jede der erkannten Pendelmoden ein abgeleiteter Verlauf der elektrischen Leistung gebildet wird, der ausschließlich die Frequenz der jeweiligen Pendelmode enthält, der Vergleich des künstlichen Verlaufs mit dem abgeleiteten Verlauf der elektrischen Leistung durchgeführt wird; und denjenigen zur Berechnung des künstlichen Verlaufs verwendeten Phasenwinkel als Phasenwinkel der Leistungspendelung zu ermitteln, bei dem der künstliche Verlauf und der erfasste zeitliche Verlauf oder der daraus abgeleitete Verlauf die geringste Abweichung voneinander aufweisen.

Hinsichtlich der erfindungsgemäßen Leitstelleneinrichtung gelten alle zu dem erfindungsgemäßen Verfahren voranstehend und nachfolgend gemachten Ausführungen und umgekehrt in entsprechender Weise, insbesondere ist die erfindungsgemäße Leitstelleneinrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Leitstelleneinrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1     eine schematische Darstellung eines beispielhaften Energieversorgungsnetzes mit mehreren Generatoren;

Figur 2     ein schematisches Ablaufdiagramm zur Erläuterung eines Ausführungsbeispiels eines Verfahrens zum Bestimmen eines Phasenwinkels einer Leistungspendelung;

Figur 3     ein schematisches Blockschaltbild einer Messeinrichtung und einer Leitstelleneinrichtung;

Figur 4     ein erstes Diagramm mit einem beispielhaften Frequenzspektrum einer elektrischen Leistungspendelung;

Figur 5     ein zweites Diagramm mit einem beispielhaften Frequenzspektrum einer elektrischen Leistungspendelung; und

Figur 6     ein Diagramm zur Erläuterung der Bestimmung eines Phasenwinkels aus dem Vergleich eines künstlichen Verlaufs mit dem zeitlichen Verlauf oder einem daraus abgeleiteten Verlauf einer elektrischen Leistung.

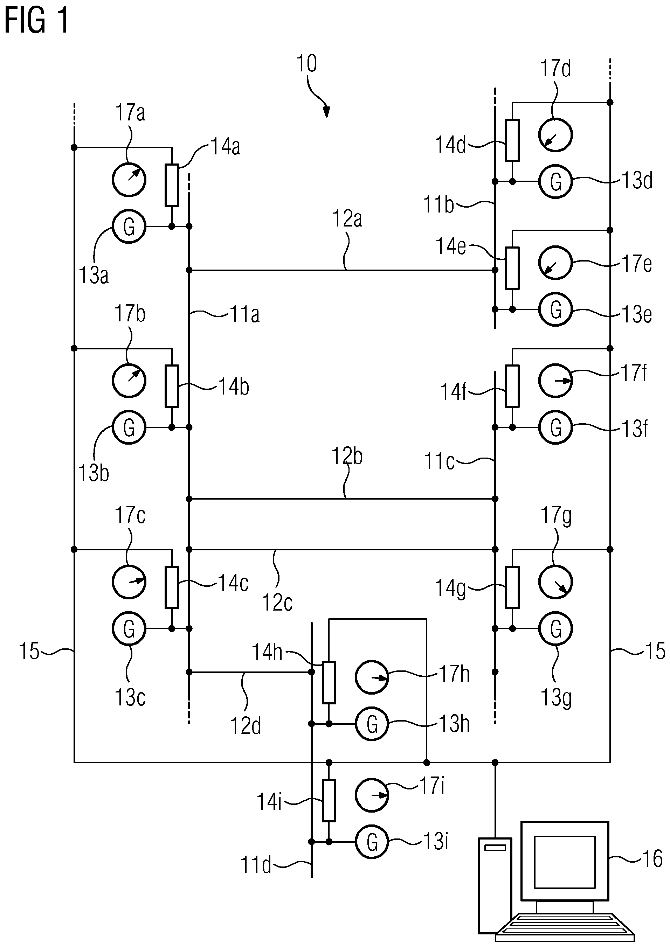

Figur 1 zeigt in einer schematischen Ansicht beispielhaft einen Teil eines elektrischen Energieversorgungsnetzes 10 in einer topologischen Darstellung. Das Energieversorgungsnetz 10 weist Unterstationen 11a-d auf, die durch Übertragungsleitungen 12a-d miteinander verbunden sind. Mit den Unterstationen 11a-d stehen über - lediglich angedeutete - Energieübertragungsleitungen elektrische Generatoren 13a-i in Verbindung und speisen elektrische Energie in das Energieversorgungsnetz 10 ein.

Unter bestimmten Umständen (z.B. nach Schalthandlungen oder Lastabwürfen) müssen sich die Generatoren 13a-i auf den neuen Netzzustand einstellen, d.h. die von ihnen ins Energieversorgungsnetz 10 eingespeiste Leistung muss einen neuen Arbeitspunkt einnehmen. Hierbei können - zumindest zeitweise - elektrische Leistungspendelungen auftreten. Häufig befinden sich dabei Gruppen von infolge geringer Impedanzen elektrisch (und damit in der Regel auch örtlich) benachbarten Generatoren in Phase und können gegen andere, elektrisch weiter entfernte Gruppen pendeln. Dies lässt sich durch eine Ermittlung des Phasenwinkels der Leistungspendelung an einer Messstelle ermitteln, die möglichst in räumlicher Nähe zum jeweiligen Generator angeordnet ist. Zur Ermittlung des Phasenwinkels werden an den Messstellen zeitgestempelte Strom- und Spannungszeiger erfasst. Dies erfolgt mit sogenannten Zeigermesseinrichtungen 14a-i bzw. Phasor Measurement Units (PMUs). Die Zeigermesseinrichtungen 14a-i sind über ein Kommunikationssystem 15 mit einer Leitstelleneinrichtung 16 verbunden, bei der es sich z.B. um einen Computer in einer Stations- oder Netzleitstelle handeln kann.

Aus aufeinanderfolgenden Strom- und Spannungszeigern werden - entweder direkt in der jeweiligen Zeigermesseinrichtung 14a-i oder nach entsprechender Übertragung der Strom- und Spanungszeiger über das Kommunikationssystem 15 an die Leitstelleneinrichtung 16 - zeitliche Verläufe einer elektrischen Leistung ermittelt, aus denen, wie später eingehender beschrieben wird, der gesuchte Wert des Phasenwinkels ermittelt wird.

In Figur 1 sind neben den Zeigermesseinrichtungen 14a-i für eine ausgewählte Pendelmode lediglich schematisch angedeutete grafische Darstellungen 17a-i des jeweils an der fraglichen Messstelle ermittelten Phasenwinkels eingetragen. Man erkennt leicht, dass die Generatoren 13a und 13b in Phase miteinander pendeln (0° Phasenwinkeldifferenz) und eine gegenphasige Pendelung zu den Generatoren 13d und 13e ausführen (180° Phasenwinkeldifferenz). Daraus lässt sich erkennen, dass zwischen der einen Gruppe aus Generatoren 13a und 13b und der anderen Gruppe aus Generatoren 13d und 13e ein elektrischer Pendelvorgang stattfindet. Generator 13c, der die gleiche Sammelschiene speist wie die Generatoren 13a und 13b, ist weniger stark an diese Generatoren angebunden als diese untereinander, zeigt jedoch eine signifikante elektrische Mitkopplung. Die an den Generatoren 13f und 13g ebenso wie die an den Generatoren 13h und 13i ermittelten Phasenwinkel deuten auf eine gewisse Mitkopplung zu den auf die untereinander an die gemeinsame Sammelschiene angebundenen Generatoren 13a, 13b und 13c hin, die in ihrer Stärke jedoch deutlich weniger ausgeprägt ist als deren Kopplung untereinander. Die eingezeichneten Phasenwinkel haben lediglich erklärenden Charakter im Rahmen dieses Ausführungsbeispiels und können in einem realen System signifikant unterschiedlich dazu vorliegen.

Die Richtung der Pfeile zur Anzeige des jeweiligen Phasenwinkels ist in Figur 1 willkürlich in Bezug auf einen Referenzwinkel gewählt. Aus der Darstellung gemäß Figur 1 geht zwar die grundsätzliche elektrische Kopplung, nicht aber u.a. hervor, wie stark der einzelne Generator jeweils von der Pendelung betroffen ist (dieses Maß könnte z.B. durch die Größe des Radius der Darstellungen 17a-i angedeutet werden). Aufgrund der der geringen Impedanzen zwischen örtlich benachbarten Generatoren ist jedoch davon auszugehen, dass innerhalb einer solchen Gruppe ähnliche relative Pendelamplituden (mit Bezug auf die aktuelle Gesamtleistung eines jeweiligen Generators) vorliegen.

Die Kenntnis über die Phasenbeziehung von einzelnen Generatoren oder Gruppen von Generatoren, die im Netz gegeneinander Leistungspendelungen ausführen (also in Phasenopposition sind), liefert zusammen mit der Kenntnis über Stärke und Dämpfung dieser Vorgänge auch Informationen über die sogenannte Kleinsignal-Stabilität, also dem Verhalten des Energieversorgungsnetzes gegenüber sich kontinuierlich verändernder Lasten und Schaltvorgängen im Energieversorgungsnetz. Dieses Wissen kann für die optimale Einstellung von Pendeldämpfungsgeräten der Erzeugungseinheiten (PSS, Power System Stabilizer) oder weiterer im Netz befindlicher Regel-Einheiten (z.B. FACTS, Flexible AC Transmission Systems) genutzt werden; ebenso können im laufenden Betrieb beim Auftreten von Pendelungen gezielt Anpassungen zur Abschwächung der Pendelamplituden vorgenommen werden.

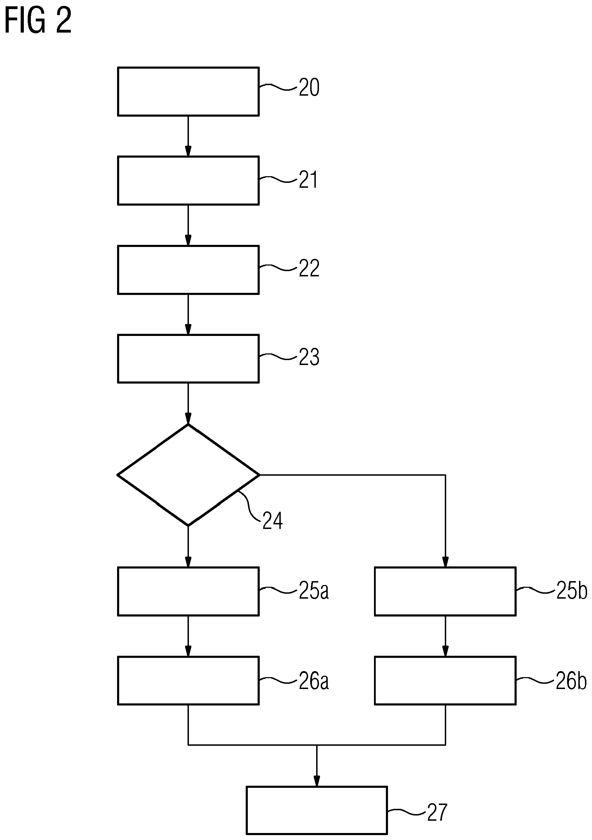

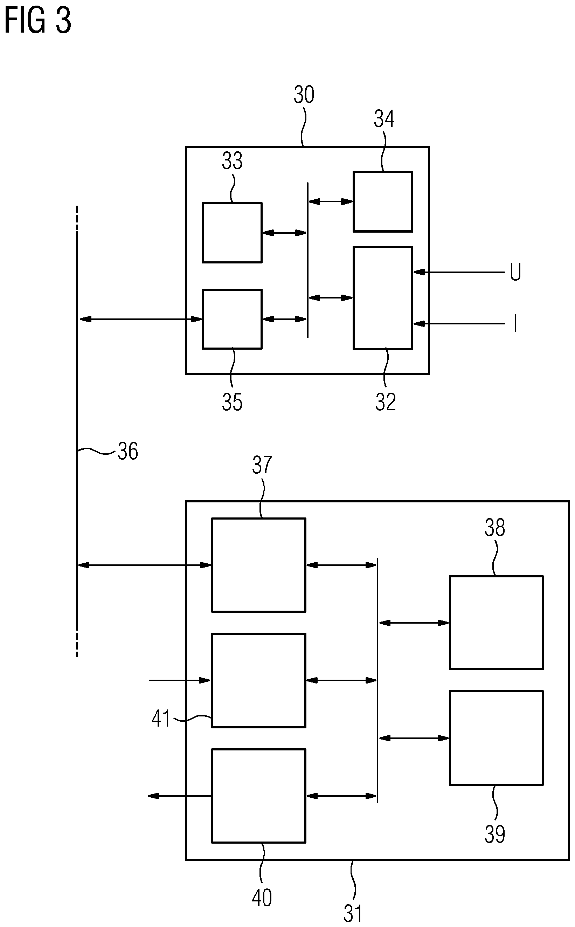

Figur 2 zeigt ein Ablaufschema zur beispielhaften Erläuterung eines Ausführungsbeispiels eines Verfahrens zur Bestimmung eines Phasenwinkels einer Leistungspendelung an einer Messstelle. Das Verfahren gemäß Figur 2 kann mittels einer Messeinrichtung 30 und einer Leitstelleneinrichtung 31, wie sie beispielhaft in Figur 3 gezeigt sind, durchgeführt werden; an geeigneten Stellen wird daher bei der nachfolgenden Beschreibung des Verfahrens gemäß Figur 2 auch auf Figur 3 Bezug genommen.

An geeignet gewählten Messstellen im elektrischen Energieversorgungsnetz, nach Möglichkeit elektrisch nah an den interessierenden Generatoren (siehe z.B. Figur 1), werden in Schritt 20 zyklisch (z.B. alle 100ms) die, z.B. über GPS, zeitlich synchronisierten komplexen Werte der elektrischen Ströme und Spannungen mittels geeigneten Messeinrichtungen 30, z.B. Zeigermesseinrichtungen (PMUs), erfasst. Hierzu dient eine Messwerterfassungseinrichtung 32 der Messeinrichtung 30. Die erfassten Strom- und Spannungswerte werden in einem nachfolgenden Schritt 21 zur Berechnung eines zeitlichen Verlaufs der elektrischen Wirkleistung verwendet. Dies kann entweder lokal in der Messeinrichtung selbst mittels einer Prozessoreinrichtung 33, die ein in einer Speichereinrichtung 34 der Messeinrichtung 30 abgespeichertes Messwertverarbeitungsprogramm ausführt, erfolgen. Die Prozessoreinheit kann alternativ auch durch eine hardwareprogrammierte Recheneinrichtung (z.B. ASIC, FPGA) gebildet sein. Alternativ kann die Ermittlung der Leistungswerte auch nach Übertragung der Strom- und Spannungswerte an eine Leitstelleneinrichtung 31 erfolgen. Dazu steht die Messeinrichtung 30 über eine Kommunikationseinrichtung 35 und ein Kommunikationssystem 36 (Kommunikationsnetzwerk, Bussystem etc.) mit einer Kommunikationseinrichtung 37 der Leitstelleneinrichtung 31 in Verbindung und überträgt an diese entweder die Rohdaten der Strom- und Spanungsmesswerte (z.B. zeitgestempelte Zeigermesswerte) oder die fertig berechneten Leistungswerte.

Anstelle der Bestimmung der Wirkleistung aus zueinander gehörenden Strom- und Spannungswerten kann diese alternativ auch aus den mittels zwei Messeinrichtungen gleichzeitig erfassten Spannungswerten und dem dazwischen liegenden Phasenwinkel bestimmt werden. Die den Verlauf der elektrischen Leistung bildenden Leistungswerte können beispielsweise in einem Speicher 38 der Leitstelleneinrichtung 31 abgelegt werden.

Sofern die Zykluszeit (z.B. 1s) für die Auswertung des Phasenwinkels der Leistungspendelung erreicht ist, wird ein Datensatz (vorgegebener Teil des Verlaufs der elektrischen Leistung) aus dem Speicher 38 ausgelesen und einer weiteren Verarbeitung, z.B. mittels einer Recheneinrichtung 39 (Prozessor, DSP, ASIC, FPGA etc.) zugeführt. Bei einer zyklischen Erfassung der Strom- und Spannungswerte alle 0,1s umfasst ein beispielhafter Datensatz z.B. eine Dauer von 12,8s (128 Werte), 25,6s (256 Werte) oder 51,2s (512 Werte).

In Schritt 22 wird der in dem ausgewählten Datensatz enthaltene zeitliche Verlauf der elektrischen Leistung von der Recheneinrichtung 39 in den Frequenzbereich transformiert. Dies kann beispielsweise durch eine an sich hinlänglich bekannte FFT- bzw. DFT-Methode erfolgen. Zuvor kann optional eine Eliminierung eines etwaigen Gleichanteils (DC-Offset), z.B. durch Subtraktion des Mittelwertes des zeitlichen Verlaufs der in dem Datensatz enthaltenen Leistungswerte, erfolgen.

Nachfolgend findet in Schritt 23 anhand des gebildeten Frequenzspektrums eine Erkennung der vorhandenen Pendelmoden sowie eine Ermittlung der zugehörigen Frequenzen und Amplituden statt. Die Pendelmoden lassen sich im jeweiligen Frequenzspektrum als vorherrschende Frequenzen ("Peaks") erkennen. Die Position solcher Peaks entspricht der Pendelfrequenz der jeweiligen Pendelmode. Die Erkennung der Peaks kann beispielsweise wie folgt durchgeführt werden:

Zunächst werden die unteren Kanäle abgeschnitten(häufig nur der unterste Kanal); auf diese Weise wird insbesondere der im Zeitsignal enthaltene Gleichanteil (DC-Offset) eliminiert. Aus dem verbleibenden Spektrum wird der Wert der höchsten Amplitude bestimmt; die Multiplikation mit einem relativen Schwellenwert, z.B. 5 %, ergibt dann einen AmplitudenSchwellenwert, der von allen nachfolgend zu ermittelnden Peaks überschritten werden muss, um als Pendelmode erkannt zu werden. Die Daten eines gefundenen Peaks werden - unter der vereinfachenden Annahme einer Gauß-Verteilung der Amplituden (korrektere Alternative: Breit-Wigner/Lorentz/Cauchy-Verteilung) - einem Least-Square-Fit unterzogen und aus den erhaltenen Parametern u.a. die Amplitude der Pendelung und deren Frequenz bestimmt.

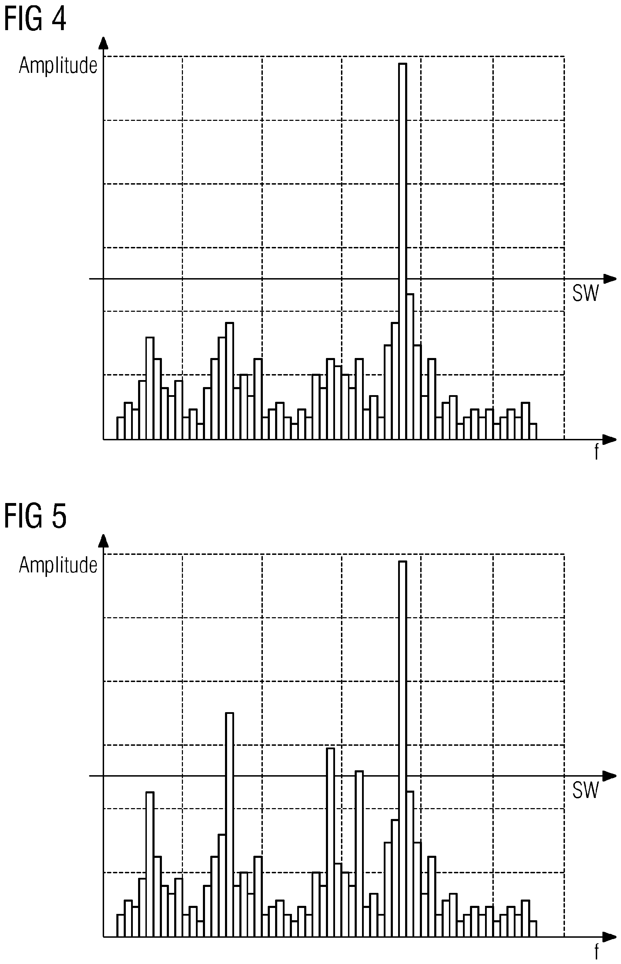

Nachfolgend wird die Fit-Kurve von dem Amplituden-Spektrum abgezogen und nach dem nächstgrößten Peak gesucht, der den Amplitudenschwellenwert überschreitet. Wird ein solcher Peak oberhalb des Amplitudenschwellenwertes nicht gefunden, wird die Peak-Suche beendet. Beispielhaft zeigt Figur 4 ein Frequenzspektrum mit einer einzigen, Figur 5 ein Frequenzspektrum mit vier erkannten Pendelmoden, jeweils im Vergleich zum verwendeten Schwellenwert SW zur Peakerkennung (Hinweis: zur besseren Erkennbarkeit ist in den Figuren ein Schwellenwert SW deutlich größer als 5% der erkannten vorherrschenden Pendelmode eingezeichnet).

In Schritt 24 wird daraufhin geprüft, ob in Schritt 23 eine oder mehrere Pendelmoden erkannt worden sind. Wurde nur eine Pendelmode erkannt, wird das Verfahren bei Schritt 25a fortgesetzt; bei Erkennung mehrerer Pendelmoden wird das Verfahren hingegen bei Schritt 25b fortgesetzt.

Sofern die Prüfung Schritt 24 ergibt, dass nur eine Pendelmode vorliegt, wird in Schritt 25a ein künstlicher Verlauf $S_k$ einer elektrischen Leistung mit der für die erkannte Pendelmode charakteristischen Frequenz $f = \omega/2\pi$ und einer an die Pendelmode angepassten Anfangsamplitude Ä, einer Dämpfung $\alpha$ und einem Startwert $\Phi_0$ für den Phasenwinkelversatz erzeugt:

$$S_k(t) = \hat{A} \cdot e^{-\alpha t} \sin(\omega t + \Phi_0) \qquad (1)$$

Als angepasst gilt die Amplitude eines künstlichen Signals, das möglichst gut den tatsächlichen zeitlichen Verlauf der erfassten Leistungswerte wiederzugeben in der Lage ist. Bei verschwindender Dämpfung ist diese Amplitude über den betrachteten Zeitraum konstant und entspricht etwa der mittleren Höhe des Messsignals; bei einem auf- oder abklingenden Signal verändert sich diese Amplitude über den betrachteten Zeitraum entsprechend der Dämpfung des Signals. Eine bestmögliche Anpassung ist in allen Fällen dann gegeben, wenn eine Minimierung der Abweichungen zwischen dem gemessenen und dem modellierten Signal erreicht ist, z.B. auf Grundlage der Quadrats des Abstandes zwischen den zugehörigen Amplituden, summiert über alle Zeitschritte im interessierenden Signalbereich.

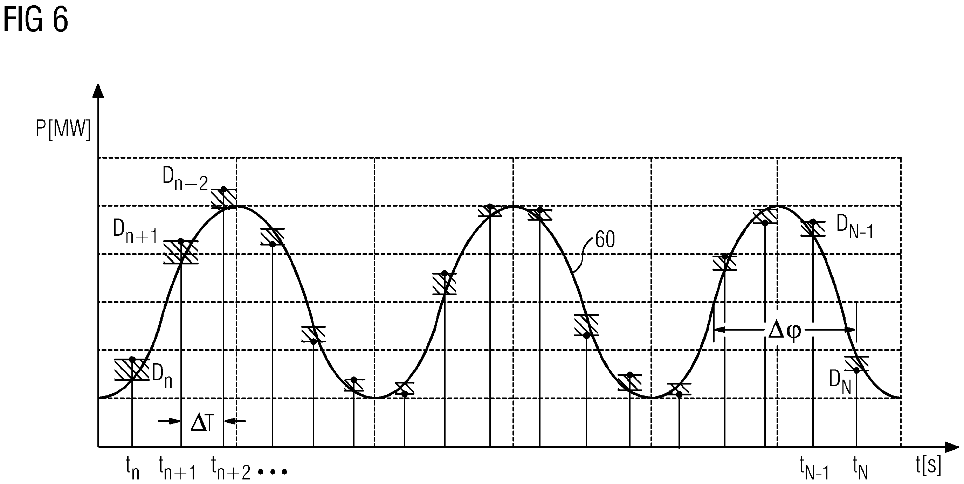

Ein Beispiel eines solchen künstlichen Verlaufs ist in dem Diagramm in Figur 6 dargestellt. Figur 6 zeigt in einem Leistungs-Zeit-Diagramm einen künstlichen Verlauf 60 der elektrischen Leistung für die Frequenz der erkannten Pendelmode.

Der künstliche Verlauf wird im Schritt 25a mit dem ursprünglich erfassten zeitlichen Verlauf der elektrischen Leistung verglichen. Im Diagramm in Figur 6 ist der ursprünglich erfasste zeitliche Verlauf durch einzelne Leistungswerte, die für die Zeitpunkte $t_n$, $t_{n+1}$, $t_{n+2}$,..., $t_N$ ermittelt worden sind, dargestellt (n steht für den Index von Leistungswerten, die jeweils um $t=\Delta T$ versetzt ermittelt werden). Verglichen mit dem künstlichen Verlauf 60 ergeben sich Abweichungen $D_n$, $D_{n+1}$, $D_{n+2}$,..., $D_n$ zwischen dem erfassten zeitlichen Verlauf und dem künstlichen Verlauf 60.

In Schritt 26a wird der künstliche Verlauf unter Variation des Phasenwinkels $\Delta\varphi$ so lange auf der x-Achse des Diagramms verschoben, bis die Summe der Abweichungen $D_n$, $D_{n+1}$, $D_{n+2}$,..., $D_n$ minimal ist. Der gesuchte Phasenwinkel $\Delta\varphi$ ist definiert als die vorzeichenrichtige Differenz zwischen dem zuletzt erfassten und im Datensatz verwendeten Zeitstempel und dem nächst benachbarten positiven Nulldurchgang des künstlichen Verlaufs.

Die optimierte Anpassung des künstlichen Verlaufs 60 an den ursprünglich erfassten Verlauf im Zeitbereich kann beispielsweise wie folgt durchgeführt werden:
Zunächst kann eine grobe Unterteilung der Phasenlage (z.B. Vielfache von 30 Grad) stattfinden und jeweils eine Ermittlung der Abweichung zwischen dem erfassten zeitlichen Verlauf und dem künstlichen Verlauf 60, z.B. auf Grundlage einer Minimierung der Fehlerquadrate für die Amplituden aller Zeitschritte, durchgeführt werden. Dieses Verfahren kann bereits ausreichend sein, um den gesuchten Phasenwinkel mit ausreichender Genauigkeit zu ermitteln. Alternativ können hieraus beispielsweise auch Startwerte für einen nachfolgenden numerischen Schritt ermittelt werden.

Anschließend können numerische Verfahren, z.B. das Newton-Raphson Verfahren, für die Parameter Phasenlage, Amplitude, Dämpfung und Frequenz angewendet werden. Das für das Aufsuchen von Nullstellen einer Funktion geeignete Newton-Raphson Verfahren stellt eine Möglichkeit zum Auffinden der geeigneten Parameter des künstlichen Verlaufs 60 zur bestmöglichen Wiedergabe der messtechnisch ermittelten Zeitverläufe der Leistung dar. Bei Modellierung der Daten im Zeitbereich durch eine abfallende (bzw. aufklingende, im Grenzfall der Figur 5 auch konstante) Sinusfunktion, sind die anfängliche Amplitude, Dämpfung, Frequenz und Phasenlage die beschreibenden Parameter. Zur Anwendung des Newton-Raphson-Verfahrens sind der künstliche Verlauf nach diesen Parametern zu differenzieren und die Nullstellen der resultierenden Funktionen (unter Bildung der zweiten Ableitung) zu bestimmen. Bei der Berechnung ist zudem die wechselseitige Abhängigkeit im Hinblick auf die Optimierung der bis zu vier unterschiedlichen Parameter zu berücksichtigen.

Die zuvor bei der Analyse des Frequenzspektrums ermittelte Frequenz kann als vergleichsweise sicher ermittelter Parameter auch als konstant betrachtet werden. Sofern die Werte von Amplitude und Dämpfung aus anderen Applikationen zur Verfügung stehen, können diese hier als Startwerte genutzt oder - im Hinblick auf eine Erhöhung der Verarbeitungsgeschwindigkeit - ebenfalls als Konstanten verwendet werden, so dass letztlich der Phasenwinkel die wesentliche Optimierungsgröße darstellt.

Ein alternatives Verfahren für die Optimierung der Parameter ist das sogenannte Gauß-Newton-Verfahren.

Wird hingegen in Schritt 24 erkannt, dass mehrere Pendelmoden vorliegen, so wird das Verfahren bei Schritt 25b fortgesetzt. In Schritt 25b wird zunächst, z.B. mittels einer inversen FFT, für alle erkannten Pendelmoden eine Rücktransformation des Frequenzspektrums in den Zeitbereich vorgenommen und so entsprechend viele abgeleitete Verläufe der Leistung ermittelt.

Dann wird für jede erkannte Pendelmode, wie für Schritte 25a und 26a bereits erläutert, entsprechend Gleichung (1) ein künstlicher Verlauf mit der charakteristischen Frequenz der Pendelmode und der angepassten Amplitude (s.o.) ermittelt. Entsprechende Paare von abgeleiteten (rücktransformierten) Verläufen und künstlichen Verläufen werden in Schritt 26b unter Variation des Phasenwinkels miteinander verglichen. Dabei werden die Optimierungsverfahren eingesetzt, die auch bereits zum Fall der einzelnen erkannten Pendelmode beschrieben worden sind.

Der entweder in Schritt 26a oder in Schritt 26b durch die Optimierung ermittelte Phasenwinkel wird schließlich in dem abschließenden Schritt 27 als Ergebnis der Phasenwinkelbestimmung bereitgestellt und z.B. für den Betreiber des Energieversorgungsnetzes 10 auf einer mit einer Ausgabeeinrichtung 40 der Leitstelleneinrichtung 31 verbundenen Anzeigeeinrichtung dargestellt und/oder weiteren Verarbeitungsschritten bzw. Applikationen einer Netzleittechnik zur Verfügung gestellt. Darüber hinaus weist die Leitstelleneinrichtung optional auch eine Eingabeeinrichtung 41 auf, mit der Eingabegeräte (Tastatur, Maus etc.) verbunden werden können, um Benutzereingaben zu tätigen.

Eine weitere Verbesserung der Genauigkeit bei der Ermittlung des Phasenwinkels lässt sich durch Wiederholung des beschriebenen Verfahrens unter Variation der Frequenz innerhalb eines vorgewählten Bereiches in der Nähe der zunächst ermittelten Frequenz der Pendelmode und anschließender Minimierung der erhaltenen Resultate nach den bereits erwähnten Methoden erreichen. Das Phasenwinkel-Frequenz-Paar, bei dem die größtmögliche Übereinstimmung eines künstlichen Verlaufs mit dem ursprünglich erfassten zeitlichen Verlauf erreicht werden kann, wird schließlich zur Festlegung des tatsächlich vorliegenden Phasenwinkels verwendet. In entsprechender Weise kann eine Verbesserung der Genauigkeit auch durch Variation anderer Parameter der Pendelmode, z.B. Amplitude, Dämpfung, erreicht werden. Durch eine Detektion des Startpunkts der Pendelung und die Auswertung allein des zeitlichen Bereiches von diesem Startpunkt bis zum aktuellen Erfassungs-Zeitpunkt kann eine frühzeitige Ermittlung und Anzeige der Phasenlage ermöglicht werden.

Das beschriebene Verfahren kann anstelle für eine einzelne Messstelle auch für mehrere Messstellen durchgeführt werden (vgl. Figur 1). Die Anwendung des beschriebenen Verfahrens zur Ermittlung und Bewertung der lokalen Phasenlage erkannter Leistungspendelungen an mehreren Messstellen innerhalb des elektrischen Versorgungsnetzes 10 versetzt den Netzbetreiber zeitnah in die Lage, die gegenseitige Ausrichtung von Pendelvorgängen in Bezug auf die im Netz angeschlossenen Generatoren zu ermitteln, was ihm Rückschlüsse auf die elektromechanische Kopplung der Generatoren erlaubt und weitergehend die Kenntnisse über mögliche Ursachen nachgewiesener Leistungspendelungen liefert. Aufgrund des so verfügbaren Wissens können wirksame Maßnahmen, wie sie gegebenenfalls zur Aufrechterhaltung des sichereren Netzbetriebes erforderlich sind, gezielt und zeitnah eingeleitet werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Bestimmen eines Phasenwinkels einer Leistungspendelung in einem elektrischen Energieversorgungsnetz (10), bei dem

   - für eine Messstelle des elektrischen Energieversorgungsnetzes (10) ein zeitlicher Verlauf einer elektrischen Leistung bestimmt wird;
   - unter Verwendung des Verlaufs der elektrischen Leistung eine Erkennung einer oder mehrerer Pendelmoden einer Leistungspendelung vorgenommen wird, indem eine Analyse von in dem zeitlichen Verlauf der elektrischen Leistung enthaltenen Frequenzen vorgenommen wird und die vorherrschenden Frequenzen als zu den vorliegenden Pendelmoden gehörende Frequenzen erkannt werden;

   **dadurch gekennzeichnet, dass**

   - für die Frequenzen der ermittelten Pendelmoden ein künstlicher Verlauf einer elektrischen Leistung berechnet wird, der einen Signalverlauf angibt, den ein Pendelvorgang der elektrischen Leistung mit einer einzigen Pendelmode idealerweise haben würde;

- der künstliche Verlauf unter Variation des zur Berechnung verwendeten Phasenwinkels mit dem erfassten zeitlichen Verlauf der elektrischen Leistung oder einem daraus abgeleiteten Verlauf verglichen wird, indem bei Erkennung einer einzelnen Pendelmode der Vergleich des künstlichen Verlaufs mit dem erfassten zeitlichen Verlauf der elektrischen Leistung durchgeführt wird oder bei Erkennung mehrerer Pendelmoden für jede der erkannten Pendelmoden ein abgeleiteter Verlauf der elektrischen Leistung gebildet wird, der ausschließlich die Frequenz der jeweiligen Pendelmode enthält, der Vergleich des künstlichen Verlaufs mit dem abgeleiteten Verlauf der elektrischen Leistung durchgeführt wird; und

- derjenige zur Berechnung des künstlichen Verlaufs verwendete Phasenwinkel als Phasenwinkel der Leistungspendelung ermittelt wird, bei dem der künstliche Verlauf und der erfasste zeitliche Verlauf oder der daraus abgeleitete Verlauf die geringste Abweichung voneinander aufweisen.

2. Verfahren nach Anspruch 1,
**dadurch gekennzeichnet, dass**

- zur Analyse der in dem zeitlichen Verlauf enthaltenen Frequenzen eine Transformation des zeitlichen Verlaufs in den Frequenzbereich durchgeführt wird; und
- diejenigen Frequenzen als vorherrschend erkannt werden, deren jeweilige Amplitude im Frequenzbereich einen Amplitudenschwellenwert überschreitet.

3. Verfahren nach einem der vorangehenden Ansprüche,
**dadurch gekennzeichnet, dass**

- der abgeleitete Verlauf der elektrischen Leistung durch Transformation eines die wesentlichen Anteile der jeweiligen Pendelmode enthaltenden Frequenzbereiches eines Frequenzspektrums des erfassten zeitlichen Verlaufs der elektrischen Leistung in den Zeitbereich gebildet wird.

4. Verfahren nach einem der vorangehenden Ansprüche,
**dadurch gekennzeichnet, dass**

- zur Bestimmung desjenigen Phasenwinkels, bei dem der künstliche Verlauf und der erfasste zeitliche Verlauf die geringste Abweichung voneinander aufweisen, ein mathematisches Optimierungsverfahren durchgeführt wird.

5. Verfahren nach Anspruch 4,
**dadurch gekennzeichnet, dass**

- als mathematisches Optimierungsverfahren die Methode der kleinsten Fehlerquadrate oder ein Newton-Raphson-Verfahren oder ein Gauß-Newton-Verfahren verwendet wird.

6. Verfahren nach einem der vorangehenden Ansprüche,
**dadurch gekennzeichnet, dass**

- der ermittelte Phasenwinkel auf einer Anzeigeeinrichtung einer Leitstelleneinrichtung (31) angezeigt wird.

7. Verfahren nach einem der vorangehenden Ansprüche,
**dadurch gekennzeichnet, dass**

- zur Bestimmung des zeitlichen Verlaufs der elektrischen Leistung an der Messstelle Messwerte von Strom und Spannung erfasst werden.

8. Verfahren nach Anspruch 7,
**dadurch gekennzeichnet, dass**

- die Messwerte von Strom und Spannung an der Messstelle als zeitgestempelte Zeigermesswerte erfasst werden.

9. Verfahren nach einem der vorangehenden Ansprüche,
**dadurch gekennzeichnet, dass**

- die Bestimmung des Phasenwinkels der Leistungspendelung für mehrere Messstellen durchgeführt wird, wobei jede Messstelle einem elektrische Energie in das Energieversorgungsnetz einspeisenden Generator (13a-i) zugeordnet ist; und
- durch Vergleich der für die einzelnen Messstellen ermittelten Phasenwinkel eine Erkennung durchgeführt wird, welche Generatoren (13a-i) elektro-mechanisch miteinander gekoppelt sind.

10. Verfahren nach Anspruch 9,
**dadurch gekennzeichnet, dass**

- solche Generatoren (13a-i), für die die ermittelten Phasenwinkel eine Differenz von näherungsweise 0° aufweisen, als phasengleich pendelnde Generatoren (13a-i) erkannt werden; und
- solche Generatoren (13a-i), für die die ermittelten Phasenwinkel eine Differenz von näherungsweise 180° aufweisen, als gegenphasig pendelnde Generatoren (13a-i) erkannt werden.

11. Verfahren nach einem der vorangehenden Ansprüche,
**dadurch gekennzeichnet, dass**

- die Ermittlung des Phasenwinkels wiederholt unter Variation der verwendeten Frequenz durchgeführt wird; und
- nachfolgend derjenige Phasenwinkel, bei dem die Abweichung zwischen dem künstlichen Verlauf und dem erfassten zeitlichen Verlauf der elektrischen Leistung oder dem daraus abgeleiteten Verlauf am geringsten ausfällt, als der tatsächliche Phasenwinkel der Leistungspendelung verwendet wird.

12. Leitstelleneinrichtung (31) zum Bestimmen eines Phasenwinkels einer Leistungspendelung in einem elektrischen Energieversorgungsnetz (10), mit

- einer Kommunikationseinrichtung (37) zum Empfang von mittels einer Messeinrichtung (30) an einer Messstelle des Energieversorgungsnetzes (10) aufgenommenen Messwerten; und
- einer Recheneinrichtung (39) zur Bestimmung eines zeitlichen Verlaufs einer elektrischen Leistung für die Messstelle aus den Messwerten, wobei die Recheneinrichtung (39) dazu eingerichtet ist, unter Verwendung des Verlaufs der elektrischen Leistung eine Erkennung einer oder mehrerer Pendelmoden einer Leistungspendelung vorzunehmen, indem eine Analyse von in dem zeitlichen Verlauf der elektrischen Leistung enthaltenen Frequenzen vorgenommen wird und die vorherrschenden Frequenzen als zu den vorliegenden Pendelmoden gehörende Frequenzen erkannt werden;

**dadurch gekennzeichnet, dass** die Recheneinrichtung (39) weiterhin dazu eingerichtet ist, für die Frequenzen der ermittelten Pendelmoden einen künstlichen Verlauf einer elektrischen Leistung zu berechnen, der einen Signalverlauf angibt, den ein Pendelvorgang der elektrischen Leistung mit einer einzigen Pendelmode idealerweise haben würde; den künstlichen Verlauf unter Variation des zur Berechnung verwendeten Phasenwinkels mit dem erfassten zeitlichen Verlauf der elektrischen Leistung oder einem daraus abgeleiteten Verlauf zu vergleichen, indem bei Erkennung einer einzelnen Pendelmode der Vergleich des künstlichen Verlaufs mit dem erfassten zeitlichen Verlauf der elektrischen Leistung durchgeführt wird oder bei Erkennung mehrerer Pendelmoden für jede der erkannten Pendelmoden ein abgeleiteter Verlauf der elektrischen Leistung gebildet wird, der ausschließlich die Frequenz der jeweiligen Pendelmode enthält, der Vergleich des künstlichen Verlaufs mit dem abgeleiteten Verlauf der elektrischen Leistung durchgeführt wird; und denjenigen zur Berechnung des künstlichen Verlaufs verwendeten Phasenwinkel als Phasenwinkel der Leistungspendelung zu ermitteln, bei dem der künstliche Verlauf und der erfasste zeitliche Verlauf oder der daraus abgeleitete Verlauf die geringste Abweichung voneinander aufweisen.

## Claims

1. Method for determining a phase angle of a power oscillation in an electrical energy supply network (10), in which

- a temporal profile of an electrical power is determined for a measurement point of the electrical energy supply network (10);
- one or more oscillation modes of a power oscillation are detected using the profile of the electrical power by analysing frequencies contained in the temporal profile of the electrical power and identifying the prevailing frequencies as frequencies belonging to the present oscillation modes;

**characterized in that**

- an artificial profile of an electrical power is calculated for the frequencies of the determined oscillation modes, which artificial profile indicates a signal profile which an oscillation process of the electrical power would ideally have with a single oscillation mode;
- the artificial profile is compared with the captured temporal profile of the electrical power or with a profile derived therefrom while varying the phase angle used for the calculation by comparing the artificial profile with the captured temporal profile of the electrical power if a single oscillation mode is detected or by forming a derived profile of the electrical power for each of the detected oscillation modes if a plurality of oscillation modes are detected, which derived profile contains only the frequency of the respective oscillation mode, and comparing the artificial profile with the derived profile of the electrical power; and
- that phase angle which is used to calculate the artificial profile and for which the artificial profile and the captured temporal profile or the profile determined therefrom have the smallest deviation from one another is determined as the phase angle of the power oscillation.

2. Method according to Claim 1,
   **characterized in that**

   - in order to analyse the frequencies contained in the temporal profile, the temporal profile is transformed into the frequency domain; and
   - those frequencies whose respective amplitude in the frequency domain exceeds an amplitude threshold value are identified as prevailing.

3. Method according to one of the preceding claims,
   **characterized in that**

   - the derived profile of the electrical power is formed by transforming a frequency range of a frequency spectrum of the captured temporal profile of the electrical power, which frequency range contains the essential parts of the respective oscillation mode, into the time domain.

4. Method according to one of the preceding claims,
   **characterized in that**

   - a mathematical optimization method is carried out in order to determine that phase angle for which the artificial profile and the captured temporal profile have the smallest deviation from one another.

5. Method according to Claim 4,
   **characterized in that**

   - the least squares method or a Newton-Raphson method or a Gauss-Newton method is used as the mathematical optimization method.

6. Method according to one of the preceding claims,
   **characterized in that**

   - the determined phase angle is displayed on a display device of a control centre device (31).

7. Method according to one of the preceding claims,
   **characterized in that**

   - measured current and voltage values are captured in order to determine the temporal profile of the electrical power at the measurement point.

8. Method according to Claim 7,
   **characterized in that**

   - the measured current and voltage values are captured at the measurement point as time-stamped phasor measured values.

9. Method according to one of the preceding claims,
**characterized in that**

- the phase angle of the power oscillation is determined for a plurality of measurement points, wherein each measurement point is assigned to a generator (13a-i) feeding electrical energy into the energy supply network; and
- it is detected which generators (13a-i) are electromechanically coupled to one another by comparing the phase angles determined for the individual measurement points.

10. Method according to Claim 9,
**characterized in that**

- those generators (13a-i) for which the determined phase angles have a difference of approximately 0° are identified as generators (13a-i) which oscillate in phase; and
- those generators (13a-i) for which the determined phase angles have a difference of approximately 180° are identified as generators (13a-i) which oscillate in phase opposition.

11. Method according to one of the preceding claims,
**characterized in that**

- the phase angle is repeatedly determined while varying the frequency used; and
- that phase angle for which the deviation between the artificial profile and the captured temporal profile of the electrical power or the profile derived therefrom is smallest is then used as the actual phase angle of the power oscillation.

12. Control centre device (31) for determining a phase angle of a power oscillation in an electrical energy supply network (10), having

- a communication device (37) for receiving measured values recorded at a measurement point of the energy supply network (10) by means of a measurement device (30); and
- a computing device (39) for determining a temporal profile of an electrical power for the measurement point from the measured values, wherein the computing device (39) is configured to detect one or more oscillation modes of a power oscillation using the profile of the electrical power by analysing frequencies contained in the temporal profile of the electrical power and identifying the prevailing frequencies as frequencies belonging to the present oscillation modes;

**characterized in that** the computing device (39) is also configured to calculate an artificial profile of an electrical power for the frequencies of the determined oscillation modes, which artificial profile indicates a signal profile which an oscillation process of the electrical power would ideally have with a single oscillation mode; to compare the artificial profile with the captured temporal profile of the electrical power or a profile derived therefrom while varying the phase angle used for the calculation by comparing the artificial profile with the captured temporal profile of the electrical power if a single oscillation mode is detected or forming a derived profile of the electrical power for each of the detected oscillation modes if a plurality of oscillation modes are detected, which derived profile contains only the frequency of the respective oscillation mode, and comparing the artificial profile with the derived profile of the electrical power; and to determine that phase angle which is used to calculate the artificial profile and for which the artificial profile and the captured temporal profile or the profile derived therefrom have the smallest deviation from one another as the phase angle of the power oscillation.

**Revendications**

1. Procédé de détermination d'un angle de phase d'une oscillation de puissance dans un réseau (10) d'alimentation en énergie électrique, dans lequel

- on détermine, pour un point de mesure du réseau (10) d'alimentation en énergie électrique, une courbe d'une puissance électrique en fonction du temps ;
- en utilisant la courbe de la puissance électrique, on reconnaît un mode ou plusieurs modes d'une oscillation de puissance, en effectuant une analyse de fréquences contenues dans la courbe de la puissance électrique en fonction du temps et en reconnaissant les fréquences prédominantes comme des fréquences appartenant au mode d'oscillation présent ;

**caractérisé en ce que**

- on calcule, pour les fréquences des modes d'oscillation déterminés, une courbe artificielle d'une puissance électrique, qui indique une courbe de signal qu'aurait eu idéalement un processus d'oscillation de la puissance électrique ayant un mode d'oscillation unique ;
- on compare la courbe artificielle avec variation de l'angle de phase utilisé pour le calcul à la courbe relevée en fonction du temps de la puissance électrique ou à une courbe qui s'en déduit, par le fait que, dans la reconnaissance d'un mode d'oscillation individuel, on effectue la comparaison de la courbe artificielle à la courbe relevée en fonction du temps de la puissance électrique ou, lors de la reconnaissance de plusieurs modes d'oscillation, on forme, pour chacun des modes d'oscillation reconnus, une courbe déduite de la puissance électrique qui contient exclusivement la fréquence du mode d'oscillation respectif, on effectue la comparaison de la courbe artificielle à la courbe déduite de la puissance électrique ; et
- on détermine l'angle de phase utilisé pour le calcul de la courbe artificielle comme l'angle de phase de l'oscillation de puissance, pour lequel la courbe artificielle et la courbe relevée en fonction du temps ou la courbe qui s'en déduit ont entre elles l'écart le plus petit.

2. Procédé suivant la revendication 1,
   **caractérisé en ce que**

   - pour l'analyse des fréquences contenues dans la courbe en fonction du temps, on effectue une transformation de la courbe en fonction du temps dans le domaine fréquentiel ; et
   - on reconnaît comme prédominantes les fréquences dont l'amplitude dans le domaine fréquentiel dépassent une valeur de seuil d'amplitude.

3. Procédé suivant l'une des revendications précédentes,
   **caractérisé en ce que**

   - on forme, dans le domaine temporel, la courbe déduite de la puissance électrique par transformation d'un domaine de fréquences, contenant les proportions essentielles des modes d'oscillation respectifs, d'un spectre de fréquence de la courbe relevée en fonction du temps de la puissance électrique.

4. Procédé suivant l'une des revendications précédentes,
   **caractérisé en ce que**

   - on effectue un procédé d'optimisation mathématique pour la détermination de l'angle de phase, pour lequel la courbe artificielle et la courbe relevée en fonction du temps ont entre elles l'écart le plus petit.

5. Procédé suivant la revendication 4,
   **caractérisé en ce que**

   - on utilise, comme procédé d'optimisation mathématique, la méthode des moindres carrés ou un procédé de Newton-Raphson ou un procédé de Gauss-Newton.

6. Procédé suivant l'une des revendications précédentes,
   **caractérisé en ce que**

   - on affiche l'angle de phase déterminé sur un dispositif d'affichage d'un dispositif (31) de poste de commande.

7. Procédé suivant l'une des revendications précédentes,
   **caractérisé en ce que**

   - on relève, pour la détermination de la courbe de la puissance électrique en fonction du temps, au point de mesure, des valeurs de mesure du courant et de la tension.

8. Procédé suivant la revendication 7,

**caractérisé en ce que**

- on relève les valeurs de mesure de courant et de tension au point de mesure sous la forme de valeurs de mesure de vecteur horodatées.

9. Procédé suivant l'une des revendications précédentes,
**caractérisé en ce que**

- on effectue la détermination de l'angle de phase de l'oscillation de puissance pour plusieurs points de mesure, chaque point de mesure étant associé à une énergie électrique dans le générateur (13a-i) alimentant le réseau d'alimentation en énergie ; et
- par comparaison des angles de phase déterminés pour les divers points de mesure, on reconnaît les générateurs (13ai) qui sont couplés entre eux électromécaniquement.

10. Procédé suivant la revendication 9,
**caractérisé en ce que**

- on reconnaît les générateurs (13a-i), pour lesquels les angles de phase déterminés ont une différence d'environ 0°, comme des générateurs (13a-i) oscillants en phase ; et
- on reconnaît les générateurs (13a-i), pour lesquels les angles de phase déterminés ont une différence d'à peu près 180°, comme des générateurs (13a-i) oscillants en opposition de phase.

11. Procédé suivant l'une des revendications précédentes,
**caractérisé en ce que**

- on effectue la détermination de l'angle de phase de manière répétée en faisant variant la fréquence utilisée ; et
- on utilise ensuite, comme angle de phase réel de l'oscillation de puissance, l'angle de phase, pour lequel l'écart entre la courbe artificielle et la courbe relevée en fonction du temps de la puissance électrique ou la courbe qui s'en déduit est le plus petit.

12. Dispositif (31) de poste de commande pour la détermination d'un angle de phase d'une oscillation de puissance dans un réseau (10) d'alimentation en énergie électrique, comprenant

- un dispositif (37) de communication pour la réception de valeurs de mesure enregistrées au moyen d'un dispositif (30) de mesure en un point de mesure du réseau (10) d'alimentation en énergie ; et
- un dispositif (39) d'ordinateur pour la détermination d'une courbe en fonction du temps d'une puissance électrique pour le point de mesure à partir des valeurs de mesure, le dispositif (39) d'ordinateur étant conçu pour reconnaître, en utilisant la courbe de la puissance électrique, un ou plusieurs modes d'une oscillation de puissance, en effectuant une analyse de fréquences contenues dans la courbe en fonction du temps de la puissance électrique et en reconnaissant les fréquences prédominantes comme des fréquences appartenant au mode d'oscillation présent ;

**caractérisé en ce que** le dispositif (39) d'ordinateur est conçu, en outre,
pour calculer, pour les fréquences des modes d'oscillation déterminés, une courbe artificielle d'une puissance électrique, qui indique une courbe de signal qu'aurait eu idéalement un processus d'oscillation de la puissance électrique ayant un mode d'oscillation unique ; pour comparer la courbe artificielle, en faisant varier l'angle de phase utilisé pour le calcul, à la courbe relevée en fonction du temps de la puissance électrique ou à une courbe qui s'en déduit, en effectuant, lors de la reconnaissance d'un mode d'oscillation individuel, la comparaison de la courbe artificielle à la courbe relevée en fonction du temps de la puissance électrique ou en formant, lors de la reconnaissance de plusieurs modes d'oscillation pour chacun des modes d'oscillation reconnus, une courbe déduite de la puissance électrique qui contient exclusivement la fréquence du mode d'oscillation respectif, en effectuant la comparaison de la courbe artificielle à la courbe déduite de la puissance électrique ; et en déterminant l'angle de phase utilisé pour le calcul de la courbe artificielle comme angle de phase de l'oscillation de puissance, pour lequel la courbe artificielle et la courbe relevée en fonction du temps ou la courbe qui s'en déduit ont entre elles l'écart le plus petit.

FIG 1

# FIG 2

FIG 3

FIG 4

Amplitude

SW

f

FIG 5

Amplitude

SW

f

FIG 6

EP 3 252 482 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013087122 A1
- US 2009099798 A1
- WO 2014056531 A2
- US 7692336 B2